# EUROPEAN PATENT APPLICATION

(11) **EP 2 650 939 A1**
(43) Date of publication of application: **16.10.2013**
(21) Application number: 11847054.1
(22) Date of filing: 07.12.2011
(51) Int. Cl.: H01L 51/42

(54) **POSITION-SENSITIVE PHOTODETECTOR, METHOD FOR OBTAINING SAME AND METHOD FOR MEASURING THE RESPONSE FROM THE PHOTODETECTOR**

(30) Priority: 10.12.2010 ES 201031818 P
(71) Applicant: Fundación Imdea Nanociencia, 28049 Madrid (ES); Consejo Superior De Investigaciones Científicas, 28006 Madrid (ES)
(72) Inventor: CABANILLAS GONZÁLEZ, Juan, E-28049 Madrid (ES); CAMPOY QUILES, Mariano, E-08193 Bellaterra (Barcelona) (ES)
(74) Representative: Ungria López, Javier
(86) International application number: PCT/ES2011/070841
(87) International publication number: WO 2012/076740

(57) **Abstract**

The photodetector comprises a continuous active layer in which, in response to incident light a signal is generated that is proportional to the incident position of the light; it is characterized in that the active layer comprises a first (1) and a second organic semiconductors (2) distributed along a longitudinal gradient, corresponding to a relative concentration gradient, a structure gradient or both.

The invention also relates to a method for obtaining the photodetector and to the method for measuring the response from the photodetector.

It makes it possible to obtain a continuous sensor of larger dimensions than those known in the prior art, thereby increasing the operating range without altering the sensitivity thereof.

## Description

### OBJET OF THE INVENTION

The present invention, as outlined in the title of this descriptive specification, refers to a position-sensitive photodetector which continuously detects the position in which a beam of incident light falls on the surface of the sensor. It aims to provide a configuration, which enables larger photodetectors that can operate within a wider range, to be manufactured.

The structure of the photodetector is obtained following a very simple process, which constitutes a further object of the invention.

Providing a method for the measurement of the photodetector response is also an additional object of the invention. This process entails measuring the current taken from the sensor when the light intensity is known and constant over time or measuring the photocurrents corresponding to two different wavelengths separately by establishing the quotient between the current of the two wavelengths that are applied alternatively to the sensor.

The invention is applicable to any sector of industry, which requires the position of something to be detected. The following industries are noteworthy:
- The security sector: the invention could be used, for example, in smoke detectors, movement detectors to detect intruders, eye scanners, electronic fingerprint detectors, etc.
- The telecommunications sector: the invention could be used, for example, in the automatic alignment and positioning of lasers or in the alignment of optical fibers.
- The information and computation technology sector: the invention could be used, for example, to centre paper in photocopiers, fax machines and scanners and touch screens or in advanced remote control systems, remote interfaces between humans and computers, remote controls for consoles, videogames and computers, etc.
- The automotive sector: the invention could be used, for example, in automatic drive and driver assistance systems among which parking sensors that detect the distance between the car and objects or obstacles in its path, can be mentioned.
- The photography and video industry: the invention could be used, for example, in sub-pixel resolution by structuring each pixel.
- The medical sector: among other reported uses, the invention could be used as an advanced optical tomography detector or in X-rays, etc.
- The construction sector: among other reported uses, the invention could be used, for example, in altimeters, used to optically measure level, etc.
- The storage industry: the invention could be used, for example, in bar code readers, electronic label detectors (tags), etc.
- Sector responsible for measuring distance: the invention could be used in applications which require physical contact with the object to be avoided, the remote detection of object trajectories in production lines and storage, as well as the alignment of machinery and tools in industrial processes such as aligning a beam of light in an optical fiber, etc.

### BACKGROUND OF THE INVENTION

Light detectors, also known as photodetectors or photoelectric detectors, are devices that turn light signals into electrical signals, which may be processed electronically. The response of a photodetector entails a current intensity at a voltage proportional to the amount of incident light (light intensity multiplied by the duration of exposure). The invention relates to a particular type of photodetectors, known as position-sensitive photodectors, which enable the intensity of incident light falling on the photodetector to be measured, also making it possible to identify the specific area on the surface of the photodetector upon which the light fell.

There are two types of position-sensitive photodetectors; the first are known as discreet position-sensitive detectors and have a structured active surface, divided into small pixels, so that through the electrical response of each of them the spatial distribution of the current is obtained, therefore making it possible to extrapolate the position of the light incidence on the surface of the sensor. The dimensions of the pixels limit the resolution of the sensor. Furthermore, the system used to read them requires fairly complex circuits in order to process the signal.

The second type of position-sensitive photodetector, constituted by a photodetector known as a continuous position-sensitive or lateral effect photodetector, is used in applications in which it is necessary to disclose the movement of an object precisely and continuously, over large trajectories. This function cannot be carried out by discreet photodetectors since small sized pixels, which form a large number of matrices are required.

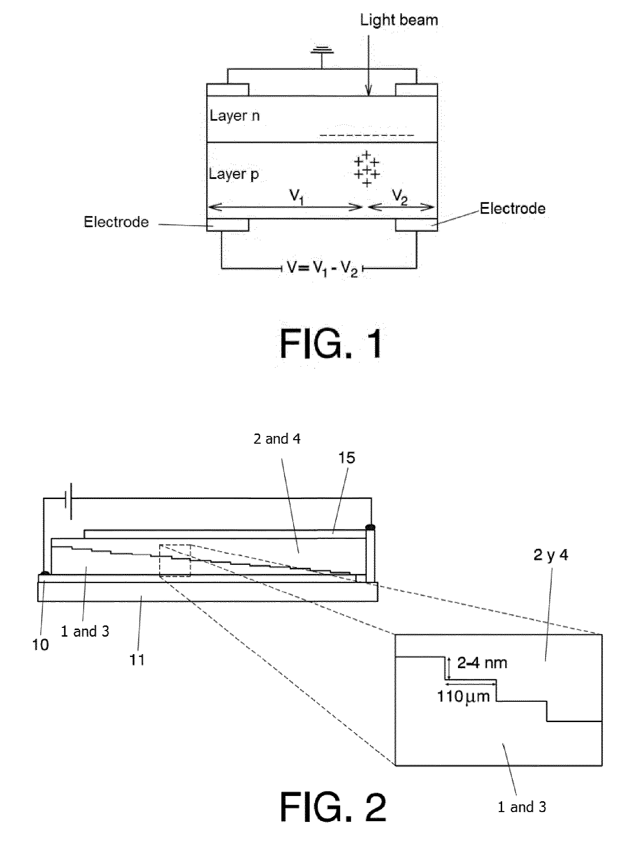

In this case and as shown in figure 1, it is based on two semi-conductive layers, p-n, one of the two being much more conductive than the other. The resistive layer (in this case, layer p), comes into contact with two metal electrodes, separated at a certain distance one from another, in such a way that when the junction p-n is lit up by a beam of light, the beam of light that is absorbed in layers p and n gives rise to charge carriers, namely electrons and voids. The charge carriers in the most conductive layer (in this case, layer n) are rapidly distributed along the parallel to the p-n junction, whilst in the lesser conductive layer (in this case, layer p) a localized, uneven density of carriers is generated. Such uneven charge distributions determine a potential difference in the longitudinal direction, parallel to the junction, if the device operates in a photovoltaic regime or a lateral displacement current if the device operates in the photodiode regime between the two electrodes.

The voltage magnitude and longitudinal currents depend on the area being lit on the plane, which facilitates the continuous detection of the light position, all along the photodetector. This type of sensor is problematic in the detection of large displacements, given that longitudinal conduction is carried out via finite conductive means, that is to say, current is dissipated as it crosses it, the maximum length of the detector therefore being limited by the charge lost through the process and the sensitivity of the photodetector. In standard applications, photodetectors smaller than 10 cm are produced and in applications which require controlling or a displacement measurement for larger ranges, this limitation must be overcome, something which, up until now, has not been achieved.

This type of sensor is manufactured using semiconductors based on active layers of silicon, which give them a wide spectral response with maximum detection in the near infrared area. This type of technology is relatively expensive in great measure, due to the fact that the manufacturing means used for the active layer require a high degree of control in the deposition of the layer and considerable energy consumption per unit area of the layer.

Moreover, over the past few years, semiconductors which may be processed by dissolution have been developed and have sparked great interest, given that the depositing techniques involved are relatively simple and compatible with large scale manufacturing, thus keeping production costs low. In this case, organic semiconductors, which employ molecules and conjugated polymers or nanostructures of semiconductors, derived from sp2 type hybridized carbon such as nanotubes or fullerenes, as well as inorganic colloidal nanocrystals are used.

Various studies have disclosed the great potential of organic semiconductors as traditional photodetectors, both when the active layer is based on small molecules and when it is based on polymers deposited by dissolution. As well as being easy to process, organic semiconductors share many aspects of the advantageous characteristic of plastic materials, such as: their low cost, flexibility and lightness. Devices based on such materials meet all the required specifications for practical applications, including high efficiency, wide dynamic range and long average lives. In fact, recently position photodetectors based on organic materials, both on the traditional structure with a lateral effect and in a similar geometry wherein the resistive layer is not the organic material but rather one of the electrical contacts, have been exhibited. Although current results are promising, simply replacing an inorganic semiconductor with an organic one does not resolve the abovementioned limitations found in existing devices.

### DESCRIPTION OF THE INVENTION

In order to fulfill the objectives and resolve the aforementioned disadvantages, the invention has developed a new position-sensitive photodetector, which, like those provided in the state of the art, comprises a continuous active layer in which a signal that is proportional to the position where incident light falls is generated in response to said incident light. One of the major novelties of the invention is that it is characterized by the fact that the active layer comprises a first and second organic semiconductor, distributed according to a configuration, which determines a longitudinal gradient in the active layer. The longitudinal gradient is either, a relative concentration gradient between the first and the second organic semiconductors, a structure gradient or a combination thereof. The first and the second organic semiconductors are arranged between two electrodes in order to measure the response of the active layer in its transversal direction, as incident light falls upon it and to detect the longitudinal position where this incident light falls.

This configuration is greatly advantageous in that it has low production costs, in addition to being easy to process, flexible, light, highly efficient and has both a wide dynamic range and long average lives, which furthermore facilitate the manufacturing of larger sensors, whilst increasing its operating range.

In one embodiment of the invention, the structure gradient is a thickness gradient in the active layer. That is to say, the thickness of the active layer of the first and second organic semiconductors varies according to a gradient, such as in the preferred embodiment of the invention, the thickness gradient of the active layer comprises a first layer of a first organic semiconductor, which acts as an electron donor and is progressively variable in thickness and a second layer of a second organic semiconductor, which acts as an electron acceptor and is progressively variable in thickness in the opposite direction so as to complement that of the first layer.

In this sense, the main configuration of the thickness gradient of the active layer is determined by the fact that the first and second layers, which are progressively variable in thickness, in the first and second semiconductors, respectively, display complementary wedge forms. In other words, as the thickness of the first organic layer decreases, the thickness of the second layer increases in the form of a wedge.

In one embodiment of the invention, the relative concentration gradient of the active layer comprises a combination of a first and second semiconductors made from organic materials, an electron donor and an electron acceptor, distributed in such a way that their concentration varies progressively along the length of the active layer; as it happens when the structure gradient is determined by the degree of crystallinity of the two organic semiconductors, as a function of the longitudinal position in the active layer. That is to say, the degree of crystallinity in the first and second semiconductor varies progressively along the length of the active layer.

The active layer is sandwiched between two electrodes, which comprise, for example, a semi-transparent anode made of indium zinc metal oxide and an aluminum cathode.

The key concept required to detect the position of the light on the surface of the active layer, in accordance with the above description, is therefore the gradual variation of concentration of the two organic semi-conductors and/or their structure, thus facilitating two operational methods, which may be used to measure the response of the photodetector, object of the invention; an average of the current extracted through the electrodes and another one based on the relative measurement at two wavelengths, which is why the photocurrent corresponding to two incident wavelengths falling on the photodetector is measured separately, before establishing the quotient of the current of the two wavelengths, applied alternately onto the active layer.

The first method requires that the current produced is proportionately dependent on the light absorbed at this point on the surface, within established thickness limits for each material. A point on the detector with greater semiconductor concentration or crystallinity or thickness absorbs more light than another, with a lower concentration or degree of crystallinity. Providing a relative concentration gradient therefore enables the amount of light absorbed to vary according to the position of the incident light beam, thus leading to a dependent generation of current, it also varies according to the place where the incident light falls. Clearly, this method may only be used when the light source is used in practical applications where the light intensity is known and it remains constant over time.

As already indicated, in the second method for measuring the response of the photodetector, a light source with two wavelengths is employed, thus rendering it possible to normalize the electrical signal so as to make it independent of the intensity of the incident light beam. This operational method is founded on the premise that each material has a characteristic photo-electric response, depending on the wavelengths of incident light, which are different one from another. That is to say, when one material absorbs the other, it is more transparent and vice versa. In this way, part of the active layer rich in one of the materials, is more sensitive to certain parts of the light spectrum (certain colors) than to others, the total photoelectric response of the active layer containing the gradient of the two organic semiconductors therefore varies according to where the incident light falls on the surface of the layer and the relative concentration of these two organic semiconductors at this point. This reasoning is also valid for the structure gradient, given that the wavelength of the maximum absorption of the mixture depends on the degree of crystallinity. Therefore, the quotient between the photocurrent measured separately at two wavelengths varies depending on the position where the incident light falls. The sensor, object of the invention, thus enables the detection of a variation in light incidence on the active layer through the change in the quotient of photocurrents at two wavelengths. Since each position in the active layer corresponds to a quotient value, the device makes it possible to establish the position of light on the active layer precisely. Since it measures the quotient between two wavelengths, this operational method is independent of achromatic fluctuations in the intensity of the incident light.

The sensor, object of the invention, alongside the two methods for measuring the response of the photodetector, makes it possible to continually detect the position of the light on the surface of the active layer and in addition, the spatial resolution is given partly by the gradient magnitude and partly by the size of the point being illuminated on the active layer. When the point being illuminated is small, gradients which facilitate a resolution of just a few hundred microns or less can be manufactured. Furthermore, the structure of the device is very simple, both in terms of manufacturing and operation, given that it only requires two contacts, which run in the transverse direction of the active layer. The separation between the contacts is constant along the length of the active layer and is given by the thickness of the same, which, in the preferred embodiment of the invention, is 100 nm. The use of the large surfaced active layers therefore does not give rise to restrictive losses, unlike the photodetectors of the prior art, in which the current is transported in distances of millimeters. This makes it possible to produce large photodetectors.

The use of organic semiconductors also makes it possible to use the invention with both, a flexible or rigid substrate, in such a way that when flexible substrate of the active layer are used, the photodetector may be used as a touch-sensitive sensor, as well as making it possible to obtain devices which are highly light sensitive within a wide spectral range, namely ultraviolet, visible and near infrared light.

Moreover, the invention also refers to the method for obtaining the position-sensitive photodetector, object of the invention, in which the wedge form in the first and second layer of the semiconductor is obtained by thermal evaporation of the organic material wherein, during its evaporation, a gradually moveable screen is interposed in order to form the wedge form.

When the active layer presents a structure that varies progressively, it is obtained by means of a depositing process by dissolution, to which an ulterior heating treatment is applied, which is carried out regulating the temperature, according to a controlled lateral gradient between the two ends of the photodetector. It is also possible for the ulterior treatment to entail regulating the exposure of the active layer to a solvent vapor, by means of a treatment in which the subsequent treatment time of the extracted layer is varied gradually in such a way that the most exposed areas provide a greater response than those, which were less exposed. The invention considers the possibility of the ulterior treatment entailing a combination of the abovementioned treatments, that is to say regulating both the temperature and the exposure of the active layer to a solvent vapor.

In order to facilitate a better understanding of this descriptive specification and as an integral part thereof, below there is a series of figures, which illustrate a non-limiting example of the object of the invention.

### BRIEF DESCRIPTION OF THE DRAWINGS

**Figure 1****. -** is a schematic representation of a conventional position-sensitive photodetector as described in the section on the background of the invention.
**Figure 2****. -** represents a first possible example of an embodiment of the invention, in which the gradient of the active layer is determined by a structure gradient, formed by a thickness gradient determined by two layers progressively variable in thickness, in opposite directions and complementary to each other.
**Figure 3****. -** is a plan view of the photodetector represented in the previous figure.
**Figures 4** **and** **5****. -** represent a method used to obtain the position-sensitive photodetector shown in figures 2 and 3.
**Figure 6****. -** represents another possible embodiment of the position-sensitive photodetector, object of the invention, formed by a crystallinity gradient.
**Figure 7****. -** represents an example of the photodetector with a crystallinity gradient shown in the above figure, to which two wavelengths are applied alternately on the active layer, thus detecting the position where the incident light falls by measuring the photocurrent corresponding to each one of the wavelengths separately and establishing the quotient of the current of said two wavelengths, which is a function of the longitudinal position in which the incident light falls.

### DESCRIPTION OF THE PREFERRED METHODS FOR IMPLEMENTING THE INVENTION

Below, is a description of the invention, based on the above mentioned figures.
Figure 1 represents a conventional photodetector whose operational process has already been described in order to facilitate a better understanding of the photodetector, object of the invention.
Figure 2 represents a first example of an embodiment of a photodetector, object of the invention, in which the active layer has a structure gradient composed of a thickness gradient, which in turn is composed of a first organic semiconductor 1, deposited according to a first layer 3, which has a progressively variable thickness, in the form of a wedge. Furthermore, the active layer comprises a second organic semiconductor 2, deposited according to a second layer 4 progressively variable in thickness, in the opposite direction and complementary to that of the first layer 3, as shown in figure 2, in such a way that both layers remain sandwiched between two electrodes, the corresponding anode and semi-transparent substrate 10 and the cathode 15, in such a way that the anode 10 is located on a glass support 11.

The anode 10 is a commercially obtained transparent anode consisting of a thin layer of indium zinc metal oxide of approximately 100 nm, deposited on a transparent substrate made of glass 11.

It must be pointed out that in the embodiment of the invention, the cathode 15 is made of aluminium.

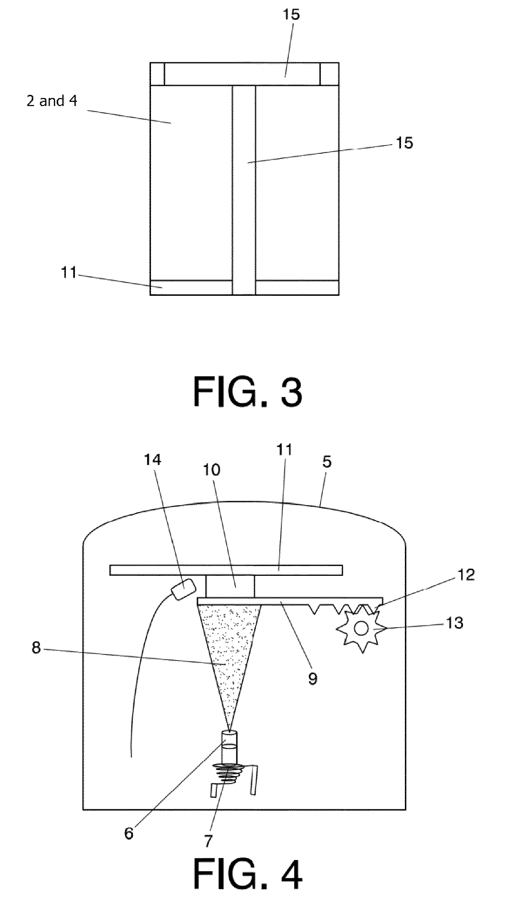

In order to obtain the photodetector, described with the help of figure 2, the method described below with the help of figures 3 and 4, shall be employed.

Therefore, this sensor is manufactured using a thermal evaporation device 5, which includes a support 11 upon which the thin layer constituting the anode and the transparent substrate 10 is arranged, as described.

The thermal evaporation device 5 has an evaporation kettle 6, in which the first organic semiconductor 1 is included, arranged over a tungsten filament 7 in order to heat the kettle and cause the evaporation of the first organic semiconductor 1, forming an evaporation cone 8 into which a screen 9 covering the anode 10 is interposed.

The screen 9 is motorized, which is why it includes a rack 12 wherein a pinion 13 is geared driven by an engine (not shown).

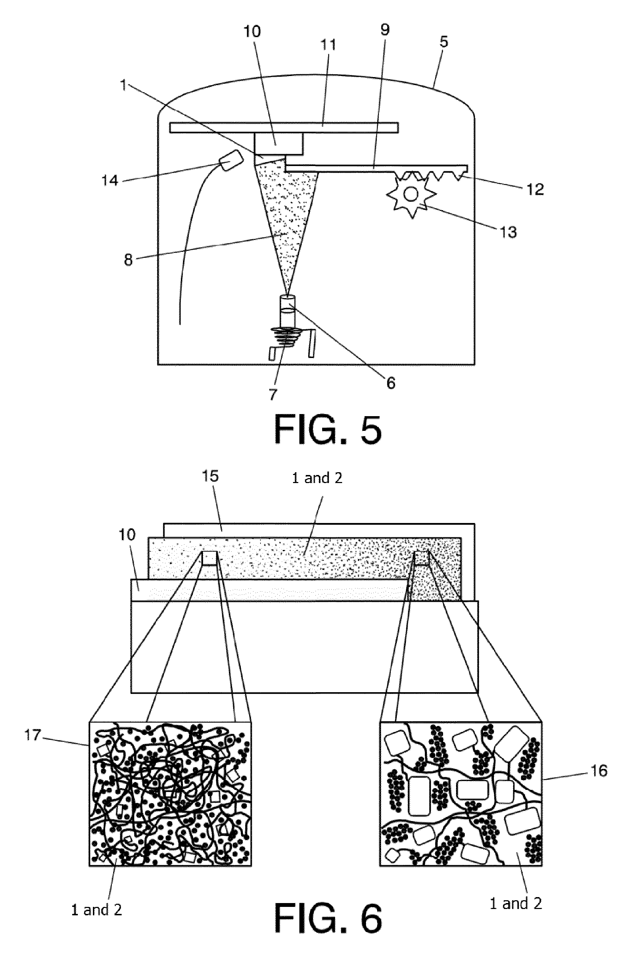

Therefore, the screen 9 initially covers the anode 10, in such a way that when the screen 9 starts moving forward, at a certain point, the end of the anode 10 is located inside the evaporation cone 8, so that the first organic semiconductor 1 begins to be deposited on the anode 10 meanwhile the screen 9 continues its movement, driven by the engine, which is started by a sensor 14 that detects the thickness of the first layer 3 that is being formed due to the deposition of the first organic semiconductor 1, as shown in figures 4 and 5.

Based on the above description, it is easy to understand that the first layer 1 settles in wedge form, in such a way that in the evaporation kettle 6, said first layer 1 subsequently is turned over and a second organic semiconductor 2 is deposited, wherein by means of the motorized screen 9 which travels in the same direction, a second layer 4 is deposited, this layer 4 being composed by the second organic semiconductor 2.

This gives rise to one single layer with a total thickness that is more or less constant along the direction of the anode.

Finally, the aluminium cathode 15, which is approximately 100 nm thick and 1 cm in length by 0.3 wide, is deposited on the second layer 4.

As shown in the detail of figure 1, the inclined plane of the first layer 3 and second layer 4 is formed with small steps created by the engine displacements, in accordance with the dimensions shown in the detail, which in this example are 110 µm in length by 2 to 4 nm in height.

Figure 6 represents another possible embodiment, in which the active layer is formed by a crystallinity gradient between the first semiconductor 1 and the second semiconductor 2, combining the two. In this case, the electrodes were deposited in the same way as described above, obtaining the anode with the semitransparent substrate 10 and the cathode 15.

In this case, the first semiconductor 1 and second semiconductor 2 are deposited by dissolution using methods such as injecting ink, spin coating, dip coating, doctor blading, etc. which are known in the state of the art and are therefore not described in more detail. In the exemplary embodiment, the first organic semiconductor 1 and second organic semiconductor 2 may be a combination of a semiconducting polymer and a fullerene or of two semiconducting polymers. The mixed layer obtained depends heavily on the treatment carried out following the deposition by dissolution. Thus, for example, the subsequent treatment includes heating and exposing the layer to a solvent vapor, in such a way that it induces a degree of crystallinity in the layers, which depends on the temperature and duration of the treatment, so that a lateral crystallinity gradient is obtained, allowing the amount of light absorbed to vary according to the position of the incident light beam, entailing a generation of current dependant of where the incident light falls on the photodetector.

In order to generate an electrical response dependent on the position of the light, a non homogeneous treatment is applied along the photodetector. For example, exposing the photodetector to a lateral temperature gradient controlled between the two ends of the photodetector during its manufacture. Thus, for example, at one of its ends, the photodetector is submitted to a cold source and at the other to a heat source, in such a way that the area exposed to the highest temperature has a greater degree of crystallinity in the active layer, which has been represented with the reference number 16, and the area exposed to a lower temperature has a lower degree of crystallinity in the active layer, which has been represented bearing the reference 17.

Another way of obtaining the configuration shown in figure 6 entails varying the exposure time to a solvent vapor, in such a way that the most exposed areas yield a greater response than those which were less exposed.

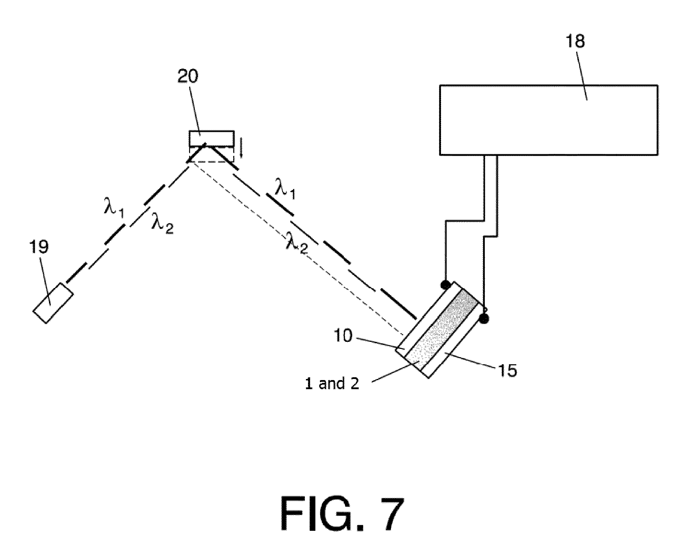

In any of the described configurations, the position of the light on the surface of the active layer may be detected using two different operational methods, one as a function of the current extracted and the other based on measurements relative to two wavelengths, as shown in figure 7.

In the method which is a function of the current extracted, the current produced is proportionally dependent on the light absorbed at this point of the surface, within thickness limits established for each semi-conductive material. A point on the detector with a higher concentration of semiconductors or greater crystallinity absorbs more light than another, having a lower concentration or degree of crystallinity. Therefore, since it is provided with a concentration gradient or lateral crystallinity, the amount of light absorbed may vary according to the position where the incident light beam falls, thereby entailing the generation of a current, which also depends on where the incident light falls. This operational method may clearly be used only when the light source employed in practical applications has a known light intensity and remains constant over time.

This is also applicable to the sensor with a variable thickness gradient described with the help of figures 2 to 5.

The second operational method uses a light source 19 with two wavelengths, λ₁ and λ₂, which allows the electrical signal to be normalized, therefore making it independent of the incident light beam. This operational method is based on the premise that each material has a characteristic photoelectric response as a function of the wavelength of the incident light that is different from each other, that is to say where one material absorbs the other It is more transparent and vice versa. In this way, part of the active layer rich in one of the materials is more sensitive to certain parts of the light spectrum than to others, therefore the total photoelectric response of the active layer containing the gradient of the two organic semiconductors varies depending on where the incident light falls on the surface of the layer and on what is the relative concentration of the two organic semiconductors at this point. Therefore, the quotient between the photocurrent measured at two wavelengths separately varies depending on the position where the incident light falls. The device thereby makes it possible to detect a variation in light incidence on the active layer via the change in the quotient of photocurrents at two wavelengths. Since each position in the active layer corresponds to a current value, the device makes it possible to determine the precise position of the light on the active layer. Measuring the quotient between two wavelengths makes this operational method independent of fluctuations in incident light intensity.

Figure 7 represents an exemplary embodiment to measure the position of an object 20 in which, when the light source 19 falls with a wavelength λ₁ and alternatively with a wavelength λ₂, the light is reflected to the active layer 1 and 2, where at the place in which incident light falls provides the position of the object 20, that is why the photocurrent corresponding to wavelengths λ₁ and λ2 is measured separately by means of a processor 18. This same circuit also establishes the quotient between the two values, in such a way that each point lit up on the surface of the active layer corresponds to a value on said quotient, therefore detecting the position of the object 20.

It must also be pointed out that the invention may be applied to obtain a continuous two dimensional photodetector by applying the concept traditionally used in photodetectors for measuring in one dimension (lateral effect). Therefore three electrodes are employed on the active layer used to detect the position in the accessible direction using the detector described in the invention, whilst another two lateral contacts are used to detect the perpendicular direction, in such a way that with three electrical readings, one on each contact, the two dimensional position on the surface of the detector may be known.

Based on the above description, it is easy to see that the invention is applicable to processes in which a certain amount of control is required on the position of an object, which is why a light emitting source 19 is needed, the photodetector composed of the organic semiconductors 1 and 2 of the invention and a signal processor 18, which reads the photocurrent in the device at two wavelengths separately. It may also be applicable to detect the alignment of a laser beam 19 in a cavity within a fiber.

The same concept may be applied, for example, for measuring length in applications in which physical contact with the object is not required, given that the device makes it possible to determine the relative distance between two points. This is carried out taking into account the quotient value of the photocurrents at two different wavelengths at the initial and final position, along with the calibration curve of the photocurrent quotient, as a function of the position.

Another possible application of the device is as a sensor to determine changes within a physical external parameter (temperature, pressure, PH, etc.). In this case, the displacement of the light on the surface of the sensor is provoked by the previous passing of the beam across a mean whose refraction index is susceptible to change, due to the external parameter to be controlled.

Finally, rather than using a substrate of glass 11, a substrate of plastic 11 is used as a support, below the anode and a semitransparent substrate 10, facilitates the use of the photoelectric device as a touch-sensitive sensor. This application is based on the mechanical deformation undergone by the plastic, which gives rise to a change in the position of the incident light falling on the active layer, which detects the deformation of the plastic and sensor, detecting its activation. Furthermore, the extent to which the plastic is deformed may also be measured through the magnitude of the displacement of the light on the surface of the active layer.

## Claims

1. **Position-sensitive photodetector,** comprising a continuous active layer in which, in response to incident light, a signal is generated that is proportional to the incident position of the light; **characterized in that** the active layer comprises first (1) and second (2) organic semiconductors, distributed according to a configuration determining a longitudinal gradient in the active layer, chosen from either a relative concentration gradient between the first (1) and the second (2) organic semiconductor, a structure gradient or a combination thereof; the first (19) and second (2) organic semiconductor being arranged between two electrodes (10 and 15) in order to measure the response of the active layer in its transversal direction, as incident light falls upon it and to detect the longitudinal position where the light falls.

2. **Position-sensitive photodetector,** according to claim 1, **characterized in that** the structure gradient is a thickness gradient of the active layer.

3. **Position-sensitive photodetector,** according to claim 2, **characterized in that** the thickness gradient of the active layer comprises a first layer (3) of a first organic semiconductor (1), which acts as an electron donor and is progressively variable in thickness; and a second layer (4) of a second (2) organic semiconductor, which acts as an electron acceptor and is progressively variable in thickness in the opposite direction and complementary to that of the first layer (3).

4. **Position-sensitive photodetector,** according to claim 3, **characterized in that** the first (3) and second (4) layers, which are progressively variable in thickness, of a first (1) and second semiconductor (2) respectively, display complementary wedge forms.

5. **Position-sensitive photodetector,** according to claim 1, **characterized in that** the relative concentration gradient of the active layer comprises a combination of a first (1) and a second semiconductor, made from organic materials (2), one of them acting as an electron donor and the other as an electron acceptor, distributed in such a way that their concentration varies progressively along the length of the active layer.

6. **Position-sensitive photodetector,** according to claim 1, **characterized in that** the structure gradient is determined by the degree of crystallinity of the organic semiconductors, as a function of the longitudinal position in the active layer.

7. **Position-sensitive photodetector,** according to claim 1, **characterized in that** the active layer with the electrodes is arranged on a substrate (11) chosen from either a rigid substrate or a flexible substrate, to constitute, in the latter case, a touch-sensitive sensor.

8. **Position-sensitive photodetector,** according to claim 1, **characterized in that** the electrodes comprise a transparent anode of indium zinc metal oxide, deposited on a semitransparent substrate and an aluminum cathode (15), between which the active layer is sandwiched.

9. **Position-sensitive photodetector,** according to claim 1, **characterized in that** the active layer is 100 nm in thickness.

10. **Method for obtaining a position-sensitive photodetector,** according to claim 4, **characterized in that** the wedge form of the first (3) and second layer (4) of the semiconductor is obtained through the thermal evaporation of the organic material, in the evaporation process of which a gradually moveable screen (9) is interposed to shape the wedge form.

11. **Method for obtaining a position-sensitive photodetector,** according to claim 1, **characterized in that** the active layer, with a progressively variable structure, is obtained by means of a process of deposition by dissolution, to which an ulterior treatment is applied, chosen from either a heating treatment carried out regulating the temperature according to a controlled lateral gradient between the ends of the photodetector; or regulating the active layer disposition by means of a solvent vapor, by means of a treatment in which the subsequent treatment time of the deposited layer varies gradually; or a combination thereof.

12. **Method for measuring the response of a position-sensitive photodetector,** according to claim 1, **characterized in that** the measure of the response of the active layer in its transversal direction, entails measuring by either measuring the current extracted through the electrodes, when the intensity of the light is known and remains constant over time; or measuring the photocurrent corresponding to the two wavelengths (λ₁ y λ₂) separately and establishing the quotient of the current of the two wavelengths, applied alternately on the active layer.
